# EUROPEAN PATENT APPLICATION

(11) **EP 3 716 317 A1**
(43) Date of publication of application: **30.09.2020**
(21) Application number: 18880154.2
(22) Date of filing: 22.11.2018
(51) Int. Cl.: H01L 21/67

(54) **GAS TREATMENT APPARATUS**

(30) Priority: 22.11.2017 KR 20170156781
(71) Applicant: CSK Inc., Gyeonggi-do 17030 (KR)
(72) Inventor: CHOI, Yun Soo, Cheonan-si Chungcheongnam-do 31093 (KR); KO, Chan Kyoo, Cheonan-si Chungcheongnam-do 31093 (KR)
(74) Representative: Norton, Ian Andrew
(86) International application number: PCT/KR2018/014435
(87) International publication number: WO 2019/103483

(57) **Abstract**

This invention relates to a gas treating apparatus. More specifically, one embodiment of this invention can provide a gas treating apparatus comprising a duct component formed from a flow channel wherein gas to be treated flows; an interior cover component installed on the outside of the circumferential surface of said duct component; and a solution supply apparatus connected to a vaporisation chamber formed between said duct component and said interior cover component to inject reaction solution into said vaporisation chamber, wherein said duct component is provided so that the heat of said gas to be treated is conveyed to said reaction solution injected into said vaporisation chamber.

## Description

### [Field of the Invention]

The present invention relates to a gas treating apparatus.

### [Technical Background]

Low-pressure chemical vapour deposition (LPCVD) and nitride process can be applied in the production of semiconductors and displays, and various gases can be used in these processes. For example, in the semiconductor manufacturing process, acidic gases such as BCl₃, Cl₂, F₂, HBr, HCl, HF and PFCs such as CF₄, CHF₃, C₂F₆, C₃F₈, C₄F₈, C₄F₆, C₄F₈, C₅F₈ and SF₆ are used to etch the surface of the wafer, while for the deposition of the wafer surface, gases such as AsH₃, NH₃, PH₃, SiH₄, SiH₂Cl₂ can be used, while for the washing stage, PFCs such as NF₃, C₂F₆ and C₃F₈ can be used.

Methods for removing the above-mentioned PFC gases include direct combustion, indirect heating, use of a catalyst, removal by plasma, etc. The direct combustion method uses flames of 1,400 to 1,600°C wherein liquefied natural gas (LNG) or hydrogen is combusted to oxidise the PFC gases, thereby removing them by converting them to carbon dioxide, fluorine (F₂) and HF gases. This direct combustion method uses liquefied natural gas, and thus is not only difficult to utilise in conventional processes with no existing feed equipment, safety measures are also needed in response to the risk of fires and explosions. There is the additional disadvantage of the increased costs needed to treat the PFC gases in the direct combustion method at high temperatures of 1,400 to 1,600°C. A further problem is the vast quantities of nitrogen oxides (NOx) produced by the combustion, which cause acid rain and photochemical smog, causing secondary air pollution.

The indirect heating method uses a heater to indirectly raise the temperature of the reactor, thereby oxidising the PFCs to remove them. According to such an indirect heating method, the PFC gases are treated at a temperature in the range of 800 to 1,000°C, making it difficult to remove PFC gases such as CF₄ that are difficult to decompose. Furthermore, high-temperature heating in the indirect heating method reduces the heater's life, making continuous wafer production difficult.

A catalyst is used in the catalyst method to remove PFC gases at a low temperature range (800°C). When the catalyst method is used, PFC gases are treated by being transformed into solid oxides such as Al2O3, SiO2 etc., introduced during the etching or CVD processes. However, solid oxides are deposited in the catalyst layer and end up blocking the channel of flow through the catalyst layer, increasing pressure damage to the catalyst layer. Another shortcoming is that if acidic substances arising from the decomposition of PFC gases are drawn into the catalyst layer, these acidic substances can be absorbed into the catalyst and react, irreversibly degrading the activity of the catalyst.

Because direct combustion, indirect heating and catalyst methods have the above-mentioned shortcomings, the plasma method has been receiving attention in treating PFC gases. In the plasma method, a plasma generating apparatus is used to generate high-temperature plasma used to decompose the PFC gases, thereby removing them. However, halogen elements such as Cl, F and Br or compounds and the like thereof generated in the process of using plasma-generating apparatus to treat harmful gases are not completely treated, they can cause corrosion not just to the inside of the apparatus, but also to exhaust ducts and the like. Furthermore, by-products of NOx and the like are also generated, which can contribute to atmospheric pollution if not controlled.

### [Invention]

### [Problem to be solved]

The embodiments of this invention have been invented with the above-mentioned existing problems in focus, in order to provide a gas treating apparatus able to increase the efficiency of processing such halogen compounds in a gaseous state such as PFC gases, and reduce the amount of such by-products such as the nitrogen oxides produced.

### [Method of solving problem]

According to one aspect of the present invention, a gas treating apparatus comprising a duct component formed from a flow channel inside of which the gas to be treated flows; an inner cover component arranged on the outside of the circular surface of the duct component; and a solution supply apparatus to inject reaction solution into a vaporisation chamber formed between the duct component and the inner cover component, and connected to said vaporisation chamber, wherein said duct component supplies said gas to be treated so that the heat of said gas to be treated is conveyed to said reaction solution injected into said vaporisation chamber can be provided.

Also, a gas treating apparatus comprising a pipe separated from the inner cover component surrounding the circumferential surface of the duct component can be provided.

Also, a gas treating apparatus comprising an external cover component installed on the outer circular surface of the inner cover component to form a cooling chamber for the flow of refrigerant; and further comprising a cooler supplying refrigerant to the cooling chamber, said cooling chamber being provided between the inner cover component and the outer cover component, can be provided.

Also, a gas treating apparatus wherein the inner cover component comprises a pipe surrounding the circumference of the duct component and separated from the duct component, while the external cover component comprises a pipe surrounding the inner cover component and separated from the inner cover component can be provided.

Also, a gas treating apparatus further comprising a connection unit connected to the duct component and internal cover component to secure the internal cover component, the cooler having a refrigerant pipe connected to the connection unit to supply refrigerant to the cooling chamber and connected to the cooling chamber; and a refrigerant pump to provide propelling force for the circulation of the refrigerant through the refrigerant pipe can be provided.

Also, a gas treating apparatus further comprising a connection unit to secure the inner cover component connected to the duct component and internal cover component can be provided.

Also, a gas treating apparatus wherein the solution supply apparatus comprises a reaction solution pipe connected to the connection unit to supply reaction solution, a piercing hole formed in the connection unit in order to connect the duct and the reaction solution pipe, and the reaction solution flowing from the reaction solution pipe through the piercing hole of the connection unit which is then injected into the vaporisation chamber, can be provided.

Also, a gas treating apparatus comprising a 1st connection unit connected to the tip of the upper side of the internal cover component; and a 2nd connection unit connected to the tip of the lower side of the internal cover component and the internal cover component can be provided.

Also, a gas treating apparatus wherein the connection unit comprises the internal cover component and a flange extending to the exterior thereof can be provided.

Also, a gas treating apparatus provided with a gap to supply reaction solution to the vaporisation chamber in the upper side of the internal cover component can be provided.

Also, a gas treating apparatus provided with a reaction gas supply aperture to connect the vaporisation chamber and flow channel in the upper side of the duct component, the reaction solution being vaporised in the vaporisation chamber through the reaction gas supply aperture, and the reaction gas thus generated is drawn in through the duct, can be provided.

Also, a gas treating apparatus wherein the reaction gas supply aperture is formed such that the upper edge of the duct component is positioned underneath the upper edge of the internal cover component can be provided.

Also, a gas treating apparatus further comprising a connection unit connected to the duct component and interior cover component to secure the interior cover component, wherein the reaction gas supply aperture supplied by means of a gap formed by the upper edge of the duct component being separated from the connection unit can be provided.

Also, a gas treating apparatus further comprising an oxidisation component installed in the lower part of the vaporisation chamber can be provided.

Also, a gas treating apparatus further comprising a heating apparatus to heat the gas to be treated, wherein the duct component is installed downstream from the heating apparatus and is supplied with heated gas to be treated from the heating apparatus, can be provided.

Additionally, said heating apparatus can comprise a plasma generation apparatus that generates plasma by applying electrical voltage to a negative electrical pole, and a negative electrical pole installed in the space where said gas to be treated flows,

The plasma generated by said plasma generating apparatus can be supplied by reacting with said gas to be treated in said flow channel.

### [Effects of the Invention]

The embodiments of this invention has the effect of improving the efficiency of treating halogen compounds in a gaseous state, including PFC gases.

They also have the effect of reducing the amount of nitrogen oxides generated in the process of treating the gas to be treated.

### [A Brief Explanation of the Drawings]

Drawing 1 is a profile of the gas treating apparatus of embodiment 1 of this invention.

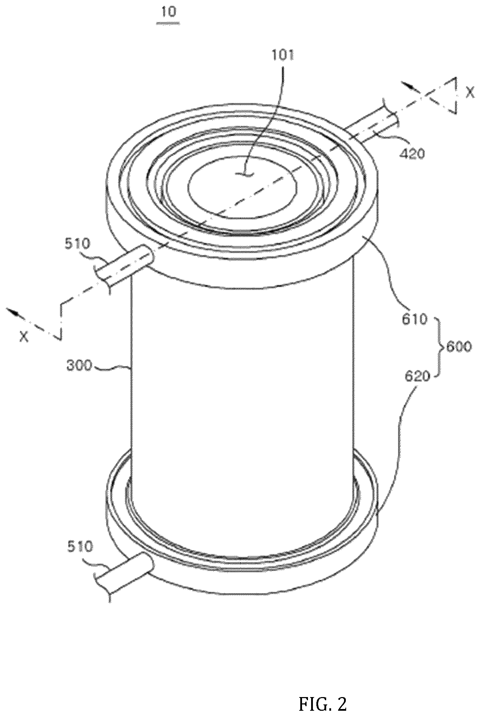

Drawing 2 shows a perspective view of the part supplied with reaction solution in the gas treating apparatus of Drawing 1.
Drawing 3 shows a vertical section of the gas treating apparatus cut across X-X in Drawing 2.
Drawing 4 shows a vertical section of a gas treating apparatus of variant example 1 of embodiment 1.
Drawing 5 shows a vertical section of a gas treating apparatus of variant example 2 of embodiment 1.
Drawing 6 shows a vertical section of a gas treating apparatus of variant example 3 of embodiment 1.
Drawing 7 shows a vertical section of a gas treating apparatus of variant example 4 of an embodiment 1.
Drawing 8 shows a vertical section of a gas treating apparatus of variant example 5 of an embodiment 1.

### [Specific examples to illustrate this invention]

The following is a detailed explanation of the specifics of the embodiments with reference to the drawings.

Detailed explanations are omitted where it has been judged that the disclosed configuration and functions are sufficient to grasp the overall gist of the invention.

Furthermore, whenever any components are "connected" or are "supplied", it must be understood that while different components can be connected or supplied, other intermediate components may also exist.

The terminology in these specifications are merely used to describe a specific embodiment and are not intended to limit this invention. Expressions in the singular also include the plural meaning unless explicitly stated.

Furthermore, expressions such as upper side, lower side and lateral surface are based on the directions illustrated in the drawings and would be expressed differently if the object under discussion is altered.

The gas to be treated drawn into the gas treating apparatus (1) can be heated while flowing through the specified route in the gas treating apparatus (1), and can react with the reaction gas while flowing. For example, the gases to be treated by the gas treating apparatus (1) can include Cl2, HCl and PFCs. Harmful components in the gas to be treated can be removed by heating and reacting with the reaction gas.

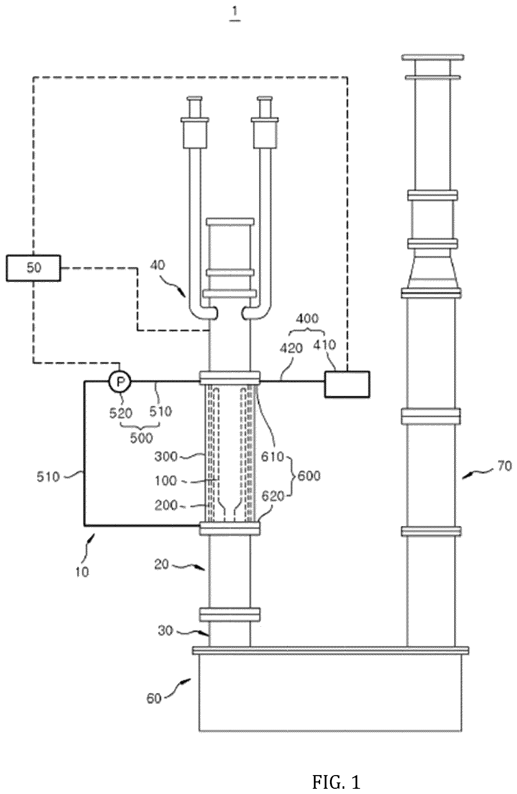

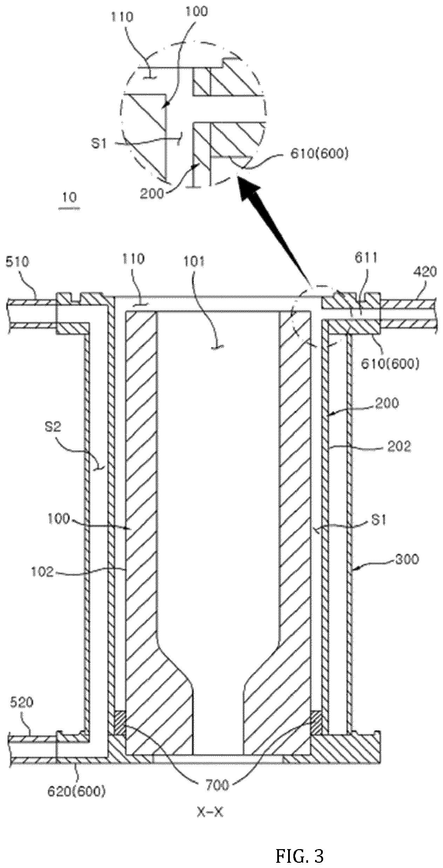

The following is an explanation of the specific configuration of the gas treating apparatus according to an embodiment of this invention, with reference to Drawing 1 and Drawing 3.

With reference to Drawing 1 and Drawing 3, the gas treating apparatus (1), according to Embodiment 1 of this invention, can comprise the reaction unit (10), DeNOx unit (20), quenching unit (30), heating apparatus (40), control unit (50), wastewater treatment unit (60) and post-processing unit (70).

Reaction unit (10) can comprise the duct component (100), internal cover component (200), external cover component (300), solution supply apparatus (400), cooler (500), connection unit, (600) and oxidisation component (700).

The duct component (100) can provide the flow channel (101) through which the gas to be treated flows on its interior. As an example, the duct component (100) can be a tube extending toward the ground from the lower side of the heating apparatus (40). The flow channel (101) can be provided on the inside of duct component (100), while the vaporisation chamber (S1) can be provided on the exterior of the duct component (100) by being formed by the interior cover component (200). The duct component (100) can be installed and secured by connection unit (600). Such a vaporisation chamber (S1) can provide a space wherein the reaction solution is heated by the gas to be treated, which is injected by the solution supply apparatus (400) to vaporise. In other words, reaction solution injected into the vaporisation chamber (S1) can be heated by the heat of the gas to be treated to thereby vaporise.

Duct component (100) can provide the gas supply hole (110) that connects the flow channel (101) and vaporisation chamber (S1). The reaction gas generated by the vaporisation of the reaction solution in the vaporisation chamber (S1) can be drawn into the flow channel (101) through the reaction gas supply aperture (110). Such reaction gas supply aperture (110) can be provided on the upper side of duct component (100). For example, the reaction gas supply aperture (110) can be a gap formed by the duct component (100) separated by a certain distance from another component such as the heating apparatus (40), as in Drawing 3. When the gas supply hole (110) is formed by a gap, the gap can be formed by the upper edge of the duct component (100) being located below the upper edge of the interior cover component (200).

Such duct component (100) can be configured so that the heat of the gas to be treated in the flow channel (101) can be easily conveyed to the reaction solution inside the vaporisation chamber (S1). Furthermore, the duct component (100) can prevent corrosion by being formed from a material containing ceramic. Additionally, the flow channel (101) inside the duct component (100) can perform the role of a reaction section where the gas to be treated is thermally decomposed by a heating apparatus (40) such as a plasma generation apparatus.

The interior cover component (200) can be installed on the circumferential surface (102) of the duct component (100) so as to form the vaporisation chamber (S1). Additionally, the interior cover component (200) can be configured to surround part of the duct component (100) without completely surrounding the circumferential surface (102) thereof. Additionally, the internal cover component (200) can be installed and secured by the connection unit (600). The vaporisation chamber (S1) can be formed surrounding the duct component (100) and the interior cover component (200). Such a vaporisation chamber (S1) can be formed long to extend toward the ground. Furthermore, the interior cover component (200), as an example, can extend in the same direction as the direction of extension of the duct component (100), and can be a pipe surrounding the circumference of the duct component (100) and installed separated from the duct component (100). In such a case, the duct component (100) can be installed on the inside of the interior cover component (200) and the vaporisation chamber (S1) can have a ring form when observed in cross-section. Moreover, when the interior cover component (200) is a pipe, it can be installed coaxially with the duct component (100).

On the other hand, Drawing 3 shows the vaporisation chamber (S1) connected to the reaction solution pipe (420), to be described later, through the piercing hole (611) formed in the connection unit (600), but this invention is certainly not limited to such.

The exterior cover component (300) can at least partially surround the exterior circumferential surface (202) of the interior cover component (200) in order to form the cooling chamber (S2). For example, the exterior cover component (300) can be installed separated from the exterior circumferential surface (202) of the interior cover component (200). The exterior cover component (300) can be installed and secured by the connection unit (600). The cooling chamber (S2), for the flow of refrigerant, can be provided on the inside of such external cover component (300). The cooling chamber (S2) can be a space formed surrounding the exterior cover component (300) and interior cover component (200). Such external cover component (300) can be, for example, a pipe installed surrounding the interior cover component (200) and separated from the interior cover component. In this case, the interior cover component (200) can be installed on the inside of the exterior cover component (300). Furthermore, when exterior cover component (300) is a pipe, it can be installed coaxially with the duct component (100) and interior cover component (200).

Alternatively, Drawing 3 shows the cooling chamber (S2) connected to the refrigerant pipe (510), to be described later, through the piercing hole formed in the connection unit (600), but this invention is certainly not limited to such.

The solution supply apparatus (400) is connected to the vaporization chamber (S1) so as to allow interflow and is able to supply a reaction solution to the vaporization chamber (S1). Reaction solution supplied by the solution supply apparatus (400) can be constituted of components that react with harmful substances, stabilise, and become harmless or are transformed into substances that dissolve well in water, or a mixture thereof. For example, reaction solution can include substances such as water, ammonia, alcohol, hydrogen peroxide solution and other substances containing hydrogen (H). Reaction solution vaporises to become reaction gas due to the heat of the gas to be treated flowing through flow channel (101) in the vaporization chamber (S1).

The solution supply apparatus (400) can comprise the reaction solution tank (410), reaction solution pipe (420) which connects the reaction solution tank (410) and vaporization chamber (S1). Additionally, the solution supply apparatus (400) can supply a small amount of solution to the vaporization chamber (S1). The amount of reaction solution supplied by the solution supply apparatus (400) can be controlled by the control unit (50). For example, when the gas to be treated is Cl2, the solution supply apparatus (400) can be configured to supply a reaction solution to the vaporisation chamber (S1) at a rate of between 0.8cc/min or more and 45cc/min or less.

Additionally, the reaction solution can be supplied at a stoichiometric ratio of between 1.5 and 2 times the amount of harmful components in the gas to be treated. For example, as shown in [Table 1] below, when the gas to be treated flows along the flow channel (101) at a flux of 90 SLM and the amount of the harmful component Cl2 contained is 1 SLM, water (H2O) can be supplied as the reaction solution at a rate of between 1.2cc/min and 1.6cc/min. Thus, as a greater amount of reaction gas is supplied than the stoichiometric ratio of harmful components in the gas to be treated, there is a significant reduction in the concentration of Cl2 and NOx emissions.

**[Table 1]**

| Test conditions | | | | Emissions | |
|---|---|---|---|---|---|
| Amount of harmful component (Cl₂) in SLM | Amount of gas to be treated (SLM) | Energy used by heating apparatus [kW] | Amount of reaction solution (H₂O) supplied (MFC) [cc/min] | Harmful component (CI₂) emissions [ppm] | NOx emissions [ppm] |
| 1 | 91 | 8.75 | 1.6 | 0.18 | 62 |
| | | 8.75 | 1.2 | 0.23 | 33 |

The reaction solution pipe (420) can be configured to inject the reaction solution at the upper tip of the vaporization chamber (S1). In other words, the upper tip of the vaporisation chamber (S1) can be directly connected to the reaction solution pipe (420), and, as shown in Drawing 3, can be indirectly connected via a first connection unit (610) to be described later.

The cooler (500) can supply a refrigerant to the cooling chamber (S2), and can cause the refrigerant to flow in the cooling chamber (S2). If the temperature in the flow channel (101) becomes excessively high in excess of approximately 800°C, the gas to be treated will be heated and nitrogen oxides will be suddenly generated. The cooler (500) is able to prevent the temperature of the gas to be treated flowing in the flow channel (101) from rising excessively by cooling the duct component (100), and can therefore prevent the generation of nitrogen oxides. The cooler (500) can comprise the refrigerant pipe (510) connected to one side and the opposite side of the cooling chamber (S2), and the refrigerant pump (520) installed on refrigerant pipe (510) to provide propelling force for the circulation of the refrigerant. The refrigerant supplied by the cooler (500) can be water, oil or an anti-freezing solution.

The connection unit (600) can be configured to interconnect at least two out of the duct component (100), interior cover component (200) and exterior cover component (300). Such a connection unit (600) can secure the interior cover unit (200) and exterior cover unit (300), while one or more can be provided.

The connection unit (600) can comprise a 1st connection unit (610) installed on the upper part of the interior cover component (200) and a 2nd connection unit (620) installed on the lower tip of interior cover component (200). The 1st connection unit (610) can be connected to the interior cover component (200) and to the upper tip of the exterior cover component (300), and can secure the interior cover component (200) and exterior cover component (300). The 2nd connection unit (620) can be connected to the duct component (100), interior cover component (200) and the lower tip of exterior cover component (300), and can secure the duct component (100), interior cover component (200) and exterior cover component (300) to each other.

Meanwhile, in the drawings for this embodiment, the connection unit (600) can be a flange extending to the duct component (100), interior cover component (200), exterior cover component (300) and other internal and external components, but this invention is certainly not limited to such. Moreover, the drawings for this embodiment show the connection unit (600) as a separate entity to the other components, but in other examples, the connection unit (600) can be formed as a unitary construction with one or more out of the duct component (100), interior cover component (200), and exterior cover component (300).

The oxidisation component (700) can be oxidised by one or more out of the reaction solution and the reaction gas in the vaporisation chamber (S1). The oxidisation component (700) can remove the oxygen (O) component contained in the reaction gas by being oxidised. The oxidisation component (700) can be made of metal and can be installed in the lower part of the vaporisation chamber (S1).

The DeNOx unit (20) can be installed downstream from the reaction unit (10) as described above. Such a DeNOx unit (20) can reduce the amount of nitrogen oxides generated by cooling the gas to be treated. The DeNOx unit can provide a flow space connecting the reaction unit (10) and flow channel (101), and as an example, can comprise a pipe interconnecting the duct component (100) and quenching unit (30).

The quenching unit (30) can be installed downstream from the DeNOx unit (20). The quenching unit (30) can quench gas to be treated that has passed through the DeNOx unit (20), and can provide a space to connect with the flow space of the DeNOx unit (20). As an example, the quenching unit (30) can comprise a pipe interconnecting the DeNOx unit (20) and water tank unit (60).

The heating apparatus (40) can be provided upstream of the duct component (100) and can heat the gas to be treated to remove harmful components thereof. Gas to be treated that is heated in such heating apparatus (40) can flow in the flow channel (101) inside the duct component (100). Such a heating apparatus (40) can be, for example, a plasma generation apparatus to generate plasma. The plasma generation apparatus can heat the gas to be treated by generating plasma by applying an electrical voltage between a negative electrical pole and a positive electrical pole, thereby precipitating a chemical reaction in the gas to be treated. The plasma generation apparatus can include a plasma torch. The plasma torch can comprise a plasma chamber to thermally decompose gas drawn in after the etching and CVD processes at a high temperature, and plasma sparks can be generated in such a plasma chamber. The heating apparatus was described as a plasma generation apparatus above, but in other examples, the heating apparatus (40) can comprise a burner, electrical heater, etc.

The control unit (50) can be configured to control the operation of the solution supply apparatus (400), cooler (500), heating apparatus (40), etc. Sensors can be provided to detect the amount of flow and temperature etc. of gas to be treated flowing in the flow channel (101) of the duct component (100) for the purpose of control by the control unit (50). The control unit (50) can control the amount of reaction solution provided by the solution supply apparatus (400) in response to the amount and temperature of gas to be treated that is detected. For example, the control unit (50) can detect the amount of gas to be treated via sensors, and can control the amount of reaction solution supplied by the solution supply apparatus (400) so that the amount of reaction gas drawn into the flow channel (101) is in a stoichiometric ratio of between 1.5 and 2.0 the amount of harmful components in the gas to be treated. Moreover, the control unit (50) can control the cooler (500) thereby regulating the rate of flow of the refrigerant in the cooling chamber (S2) and can control the heating apparatus (40) to control the temperature of the gas to be treated. Such a control unit (50) can be implemented using computing equipment comprising a microprocessor, and such implementation needs no more detailed explanation, as it is clear to the person skilled in the relevant field of technology.

The wastewater treatment unit (60) is able to store, purify and dispose of wastewater generated by the cooling and condensation of gas to be treated as it flows through the flow channel (101), post-processing unit (70) etc.

The post-processing unit (70) can perform secondary processing of gas to be treated that has been primarily processed while flowing through the heating apparatus (40) and duct component (100). The post-processing unit (70) can inject water into the gas to be treated for such secondary processing. Secondary post-processing can process water soluble gases, acidic gases and particulate matter generated during primary processing of the gas to be treated in the reaction unit (10), DeNOx unit (20), quenching unit (30). Such water injection can be carried out using a nozzle to spray or by poling.

The following is an explanation of the operation and effect of a gas treating apparatus of the above configuration. Gas to be treated including harmful components is drawn into the heating apparatus (40) of the gas treating apparatus (1) and heated by the heating apparatus (40). The heated gas to be treated is drawn into the flow channel (101) inside duct component (100) and flows toward the post-processing unit (70).

Meanwhile, reaction solution is supplied by the solution supply apparatus (400) in the upper part of the vaporisation chamber (S1) of the gas treating apparatus (1). The reaction solution can be water, hydrogen peroxide solution and other hydrogen (H) containing substances. The reaction solution in the vaporisation chamber (S1) can be heated by the heat of the gas to be treated flowing in the flow channel (101). The heated reaction solution vaporises into reaction gas in the vaporisation chamber (101). Reaction gas in the vaporisation chamber (S1) is drawn into the flow channel (101) through the reaction gas supply aperture (110) provided in the top of the vaporisation chamber (S1). Reaction gas drawn into the flow channel reacts with such harmful components such as Cl and F to remove them from the gas to be treated.

According to the above embodiment, the waste heat generated by heating the gas to be treated is effectively used, thereby improving the efficiency of treating of the gas treating apparatus (1) . For example, when the heating apparatus (40) comprises the plasma generation apparatus, the remaining energy (waste heat) from sufficiently heating and processing the gas to be treated in the plasma generation apparatus, can indirectly heat the reaction solution. Furthermore, since the reaction solution and reaction gas supplies are not directly exposed to the heat source of the plasma generation apparatus, the risk of corrosion can be significantly reduced. Moreover, the vaporisation chamber (S1) formed on the exterior of the duct component (100), can be used to heat the reaction solution, thereby uniformly and stably vaporising the reaction solution.

Furthermore, instead of directly supplying oxygen gas (O2), the gas treating apparatus (1) of this embodiment supplies reaction gas containing hydrogen, thereby significantly reducing the amount of nitrogen oxides (NOx) generated by the reaction of the gas to be treated and the reaction gas in the flow channel (101).

Reaction gas containing harmful components can be cooled while flowing downstream, and wastewater can be generated from the gas to be treated in the cooling process. Wastewater generated from the gas to be treated is treated by the wastewater treatment unit (60), and can be emitted to the outside of the gas treating apparatus (1).

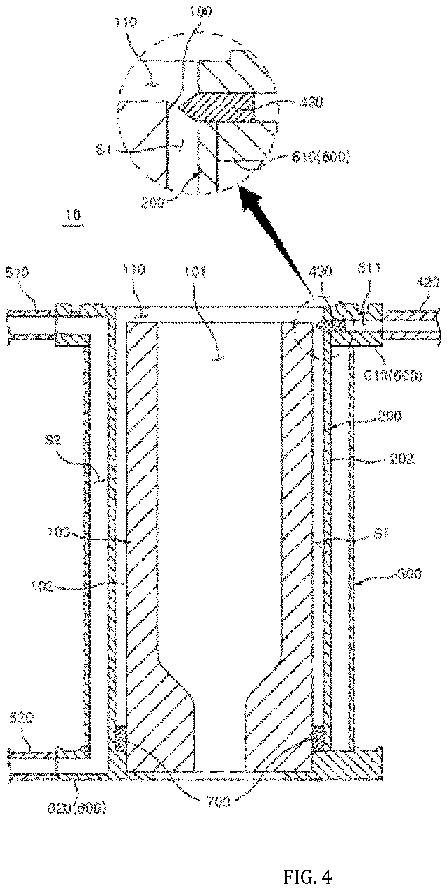

Meanwhile, the above-mentioned components can be varied so as not to depart from the scope of this invention. The following an explanation of variant examples 1 to 5 with references to Drawings 4 to 8. The variant examples are described with the focus on differences with the above-mentioned embodiments, and identical descriptions and drawing numbers will be quoted.

First is a description of variant example 1 with reference to Drawing 4. The solution supply apparatus (400) of the gas treating apparatus (1) of variant example 1 can further comprise a solution spray nozzle (430) to spray reaction solution into the vaporisation chamber (S1). Such a solution spray nozzle (430) can be installed fixed to the 1st connection unit (610) or interior cover component (200), and its operation can be controlled by the control unit (50). The solution spray nozzle (430) can regulate the amount of reaction solution supplied to the vaporisation chamber (S1). The solution spray nozzle (430) can also regulate the direction in which the reaction solution is sprayed into the vaporisation chamber (S1), and the solution spray nozzle can spray the reaction solution onto the exterior circumferential surface (102) of the duct component (100). When the reaction solution is sprayed onto the exterior circumferential surface (102), the reaction solution can be more effectively heated and vaporised.

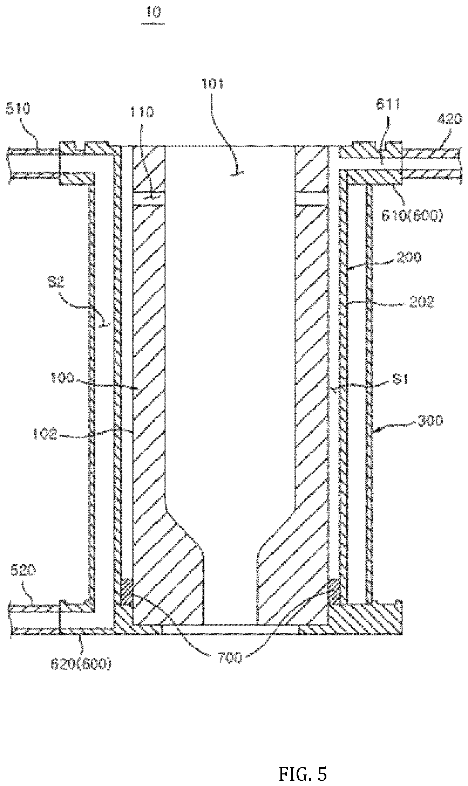

Next is a description of variant example 2 with reference to Drawing 5. Drawing 5 shows that the reaction gas supply aperture (110) of the gas treating apparatus (1) according to variant example 2 is formed to pierce the upper side of the duct component (100). In such a case, the upper tip of duct component (100) can be secured by connection to the 1st connection unit (610). Consequently, the duct component (100) can be more stably connected to the interior cover component (200) and exterior cover component (300).

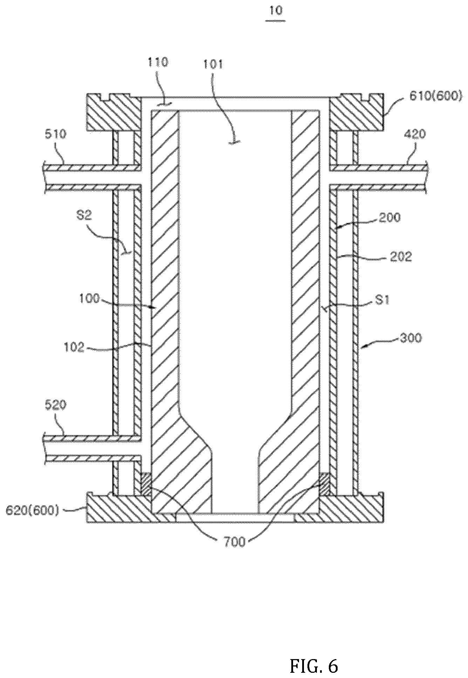

Next is a description of variant example 3 with reference to Drawing 6. Drawing 6 shows that the reaction solution pipe (420) of the gas treating apparatus (1) according to variant example 3 can pierce the interior cover component (200) and exterior cover component (300) to connect to the vaporisation chamber (S1). The refrigerant pipe (510) can also pierce the external cover component (300) to connect to the cooling chamber (S2). According to this variant example, the number of piercing holes formed in the connection unit (600) can be reduced, and the connecting and manufacturing method can be simplified by removing piercing holes formed in the connection unit (600).

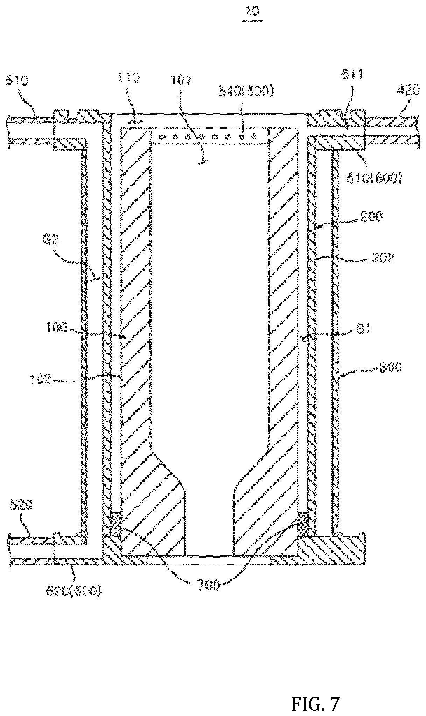

Next is a description of variant example 4 with reference to Drawing 7. Drawing 7 shows that the cooler (500) of the gas treating apparatus (1) of variant example 4 can comprise a gas spray nozzle for cooling (540) to spray low-temperature gas. The gas spray nozzle for cooling (540) can be installed in the interior circumferential surface of the duct component (100), and a plurality of nozzles set at a fixed distance apart can be provided.

Low-temperature gas can be sprayed into the flow channel (101) via the gas spray nozzle for cooling (540). A non-reactive gas or gas of low reactivity can be used. As an example, the low-temperature gas can be an inert gas including one or more out of nitrogen and argon. The temperature of the low-temperature gas should be low enough to rapidly cool gas treated upstream in the flow channel (101) to a temperature sufficiently low as to inhibit formation of nitrogen oxides, and as an example, approximately 300°C or less.

Meanwhile, high-temperature gas treated upstream in the flow channel (101) moves downstream in the flow channel (101), low-temperature gas sprayed by the gas spray nozzle for cooling (540) rapidly cools high-temperature gas to be treated and can reduce the generation of nitrogen oxides. When the gas spray nozzle for cooling (540) is installed upstream in the flow channel (101), the efficiency of the gas treatment may be reduced. If the gas spray nozzle for cooling (540) is installed further downstream in the flow channel (101), there will be less efficient reduction of nitrogen oxides generated. Thus, the gas spray nozzle for cooling (540) needs to be installed so as to satisfy both requirements of effective treatment of gas to be treated and effective reduction of nitrogen oxides. For example, if the gas spray nozzle for cooling (540) is installed in a region where the temperature of the gas to be treated is approximately 750°C to 850°C, the efficiency of treatment of the gas to be treated will not be reduced while the generation of nitrogen oxides can be effectively reduced.

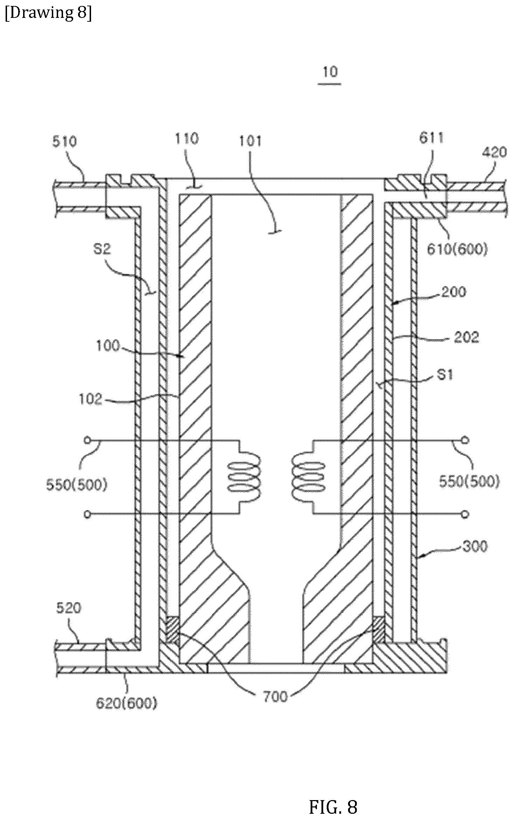

Next is a description of variant example 5 with reference to Drawing 8. Drawing 7 shows that the cooler (500) of the gas treating apparatus (1) according to variant example 5 can comprise a heat exchanger installed downstream of the flow channel (101). The heat exchanger (550) comprises a plurality of heat exchange pipes containing liquid hydrogen or other refrigerants. However, the heat exchanger (550) is not limited to heat exchange pipes, and heat-exchanging plates or tubes will suffice instead. High-temperature gas treated upstream in the flow channel (101) moves in the flow channel (101) and the heat exchanger (550) can rapidly cool high-temperature gas to be treated thereby reducing the generation of nitrogen oxides.

The above is a description of specific modes of implementation according to embodiments and variant examples of this invention. This is only a demonstration, and this invention is not limited to such examples, and must be interpreted in the widest possible range of examples based on the basic premise of the specifications of this invention. A person versed in basic knowledge of the industry can combine and substitute embodiments to implement patterns not hereby specified, but such still fall under the scope of this invention. A person with basic knowledge of the industry can easily adapt the embodiments presented in this invention, but such will clearly fall within the rights of this invention.

**[Legend]**

| | |
|---|---|
| 1: Gas treating apparatus | 10: Reaction unit |
| 20: DeNOx unit | 30: |
| 40 Heating apparatus | 50: Control unit |
| 60: Wastewater processing unit | 70: Post-processing unit |
| 100: Duct component | 101: Flow channel |
| 102: Exterior circumferential surface of duct component | |
| 200: Interior cover component | 202: Exterior circumferential surface of interior cover component |
| 300: Exterior cover component | 400: Solution supply apparatus |
| 410: Reaction solution tank | 420: Reaction solution pipe |
| 500: Cooler | 510: Refrigerant pipe |
| 520: Refrigerant pump | 600: Connection unit |
| 610: 1^{st} connection unit | 620: 2^{nd} connection unit |
| 700 Oxidisation component | |
| S1: Vaporisation chamber | S2: Cooling chamber |

## Claims

1. A gas treatment apparatus comprising a duct component formed by a flow channel wherein gas to be treated flows;
interior cover component installed on the exterior of the circumferential surface of said duct component; and
a solution supply apparatus connected to a vaporisation chamber formed between said duct component and said interior cover component, to inject reaction solution into said vaporisation chamber,
wherein said duct component is provided so that the heat of said gas to be treated is conveyed to said reaction solution injected into said vaporization chamber.

2. A gas treating apparatus according to Claim 1, formed with said interior cover component surrounding said circumferential surface of said duct component and a pipe separated from said duct component.

3. A gas treating apparatus according to Claim 1, wherein an exterior cover component installed on the outside of the circumferential surface of said interior cover component in order to form a cooling chamber for the flow of refrigerant; and
further comprising a cooler to supply said refrigerant to said cooling chamber, with said cooling chamber provided between said interior cover component and said exterior cover component.

4. A gas treating apparatus according to Claim 3, constituted with said interior cover component surrounding the circumference of said duct component and a pipe separated from said duct component,
wherein said exterior cover component surrounds said interior cover component and a pipe is provided separated from said interior cover component.

5. A gas treating apparatus according to Claim 3, further comprising a connection unit to secure said interior cover component connected to said duct component and said interior cover component,
said cooler,
comprises a refrigerant pipe connected to said connection unit and connected with said cooling chamber to supply refrigerant to said cooling chamber; and
a refrigerant pump to provide propelling force for the circulation of said refrigerant in said refrigerant pipe.

6. A gas treating apparatus according to Claim 1, further comprising a connection unit connected to said duct component and to said interior cover component to secure said interior cover component.

7. A gas treating apparatus according to Claim 6, wherein said solution supply apparatus further comprises a reaction solution pipe connected to said connection unit to supply said reaction solution to said vaporisation chamber, a piercing hole is formed in said connection unit to connect said flow channel and said reaction solution pipe,
said reaction solution flows from said reaction solution pipe through said piercing hole of said connection unit to be injected into said vaporisation chamber.

8. A gas treating apparatus according to Claim 6, wherein said connection unit further comprises a first connection unit connection unit connected to the upper tip of said interior cover component; and
said interior cover component further comprises a second connection unit connecting the lower tip of said interior cover component and said interior cover component.

9. A gas treating apparatus according to Claim 6, wherein said connection unit is constituted from a flange extending to the interior and exterior of said interior cover component.

10. A gas treating apparatus according to Claim 1, provided with a gap in the upper side of said interior cover component to supply said reaction solution to said vaporisation chamber.

11. A gas treating apparatus according to Claim 10, provided with a reaction gas supply aperture in said duct component connecting the vaporisation chamber and said flow channel,
wherein said reaction solution is vaporised in said vaporisation chamber via said reaction gas supply aperture, and the reaction gas thus generated is drawn into said flow channel.

12. A gas treating apparatus, according to Claim 11, wherein said reaction gas supply aperture is formed with the upper edge of said duct component located below the lower edge of said interior cover component.

13. A gas treating apparatus according to Claim 12, further comprising a connection unit connected to said duct component and said interior cover component and securing said interior cover component,
said reaction gas supply aperture is provided by a gap formed by having the upper edge of said duct component separated from said connection unit.

14. A gas treating apparatus according to Claim 1, further comprising an oxidisation component installed in the lower part of said vaporisation chamber.

15. A gas treating apparatus according to Claim 1, further comprising a heating apparatus to heat said gas to be treated,
wherein said duct component is installed downstream from said heating apparatus and is supplied with said heated gas to be treated from said heating apparatus.

16. A gas treating apparatus according to Claim 15, wherein said heating apparatus is constituted from a plasma generating apparatus that generates plasma by applying an electric voltage between a negative electrical pole and a positive electrical pole in a space wherein said gas to be treated flows,
and plasma generated by said plasma generation apparatus reacts with said gas to be treated in said flow channel.
